# EUROPEAN PATENT SPECIFICATION

(11) **EP 4 151 901 B1**
(45) Date of publication and mention of the grant of the patent: **18.02.2026**
(21) Application number: 22190137.4
(22) Date of filing: 12.08.2022
(51) Int. Cl.: F21K 9/00, F21S 41/141, F21S 41/143, F21S 41/19, F21S 43/14, F21V 23/00, H05K 1/02, H10H 20/857

(54) **VEHICLE LIGHTING DEVICE AND VEHICLE LAMP**
FAHRZEUGBELEUCHTUNGSVORRICHTUNG UND FAHRZEUGLAMPE
DISPOSITIF D'ÉCLAIRAGE DE VÉHICULE ET LAMPE DE VÉHICULE

(30) Priority: 17.09.2021 JP 2021151849
(43) Date of publication of application: 22.03.2023
(73) Proprietor: Toshiba Lighting & Technology Corporation, Yokosuka-shi Kanagawa 237-8510 (JP)
(72) Inventor: SHIRAISHI, Hiromitsu, Imabari-shi, Ehime (JP)
(74) Representative: Becker, Eberhard

(56) References cited:
- EP-A1- 2 993 395
- EP-A1- 3 534 061
- JP-A- 2018 152 352
- JP-A- 2020 187 979
- US-A1- 2012 007 076
- US-A1- 2016 290 621

## Description

### BACKGROUND

### Technical Field

Embodiments of the disclosure relate to a vehicle lighting device and a vehicle lamp.

### Description of Related Art

From the viewpoints of energy saving and long service life, a vehicle lighting device equipped with light emitting diodes has been widely adopted in place of a vehicle lighting device equipped with filaments. For example, a vehicle lighting device has been proposed, which includes a socket and a substrate which is provided on one end side of the socket and on which a chip-shaped light emitting diode is mounted. The light emitting diode is bonded to a mounting pad (also called an island pattern) provided on the substrate, and an electrode provided on the upper surface of the light emitting diode and a connection pad provided on the substrate are electrically connected by a wire wiring. Further, a frame part that surrounds the light emitting diode and the wire wiring, and a sealing part that is provided on the inner side of the frame part and covers the light emitting diode and the wire wiring are provided.

Here, when the light emitting diode is turned on, heat is generated and the sealing part expands. When the lit light emitting diode is turned off, the temperature of the sealing part drops and the sealing part contracts. Therefore, the sealing part has thermal deformation (expansion and contraction due to the temperature change) as the light emitting diode is turned on and off. When the sealing part is thermally deformed, stress is generated in the light emitting diode and the wire wiring covered by the sealing part.

In addition, in the case of a vehicle lighting device, the change in atmospheric temperature is large (for example, in a range of -40 °C to 85 °C). Furthermore, in recent years, there has been a demand for higher luminous flux for vehicle lighting devices, and the value of the current flowing through the light emitting diode tends to increase. As the value of the current flowing through the light emitting diode increases, the heat generated during lighting increases. Therefore, the amount of thermal deformation of the sealing part may further increase, and the stress generated in the light emitting diode and the wire wiring may further increase.

When the stress generated in the light emitting diode and the wire wiring increases, the light emitting diode may be peeled off, the wire wiring may be disconnected, or the connection portion of the wire wiring may be peeled off.

In this case, the amount of thermal deformation of the sealing part increases outward from the center of the sealing part, so if the size of the sealing part is reduced, the amount of thermal deformation of the sealing part can be reduced and eventually the stress generated in the light emitting diode and the wire wiring can be reduced. For example, the size of the sealing part can be reduced if the region in which the light emitting diode and the wire wiring are provided is made small.

However, if the region in which the light emitting diode and the wire wiring are provided is made small, the distance between the position where the wire wiring is connected to the connection pad (connection position of the wire wiring) and the light emitting diode is shortened.

Here, generally, the light emitting diode is bonded to the mounting pad using a bonding material such as a die attaching material and a die attaching sheet. Therefore, if the distance between the connection position of the wire wiring and the light emitting diode is shortened, a component of the bonding material that protrudes when the light emitting diode is bonded to the mounting pad tends to reach the connection position of the wire wiring. The wire wiring is connected to the connection pad using a wire bonding method after bonding of the light emitting diode. Therefore, if the component of the protruding bonding material reaches the connection position of the wire wiring, it becomes difficult to connect the wire wiring.

Thus, it has been desired to develop a technique that can suppress the component of the protruding bonding material from reaching the connection position of the wire wiring even if the size of the sealing part is reduced.

### Citation List

### Patent Literature

[Patent Literature 1] Japanese Patent Laid-Open No. 2013-137959

JP 2018-152352 A relates to vehicle lighting devices and vehicle lamps. The document discusses how to improve the tolerance of vehicle lighting devices and vehicle lamps to temperature changes. However, the document does not discuss how to suppress the component of the protruding bonding material from reaching the connection position of the wire wiring even if the size of the sealing part is reduced.

### SUMMARY

### Technical Problem

The disclosure provides a vehicle lighting device and a vehicle lamp that can suppress the component of the protruding bonding material from reaching the connection position of the wire wiring even if the size of the sealing part is reduced.

### Solution to Problem

The invention is set out in the appended set of claims. The following disclosure serves a better understanding of the present invention.

### Effects

According to the embodiments of the disclosure, it is possible to provide a vehicle lighting device and a vehicle lamp that can suppress the component of the protruding bonding material from reaching the connection position of the wire wiring even if the size of the sealing part is reduced.

### BRIEF DESCRIPTION OF THE DRAWINGS

FIG. 1 is a schematic exploded view for illustrating the vehicle lighting device according to the present embodiment.
FIG. 2 is a cross-sectional view taken along the line A-A of the vehicle lighting device in FIG. 1.
FIG. 3 is a schematic plan view for illustrating the connection between the wire wiring and the wiring pattern according to a comparative example.
(a) of FIG. 4 is a schematic plan view for illustrating a suppression part which does not form part of the claimed invention. (b) of FIG. 4 is a schematic enlarged view of the part B in (a) of FIG. 4.
(a) of FIG. 5 is a schematic plan view for illustrating the suppression part according to an embodiment of the invention.
(b) of FIG. 5 is a cross-sectional view taken along the line C-C in (a) of FIG. 5.
(a) of FIG. 6 is a schematic plan view for illustrating the suppression part according to another embodiment of the invention.
(b) of FIG. 6 is a cross-sectional view taken along the line D-D in (a) of FIG. 6.

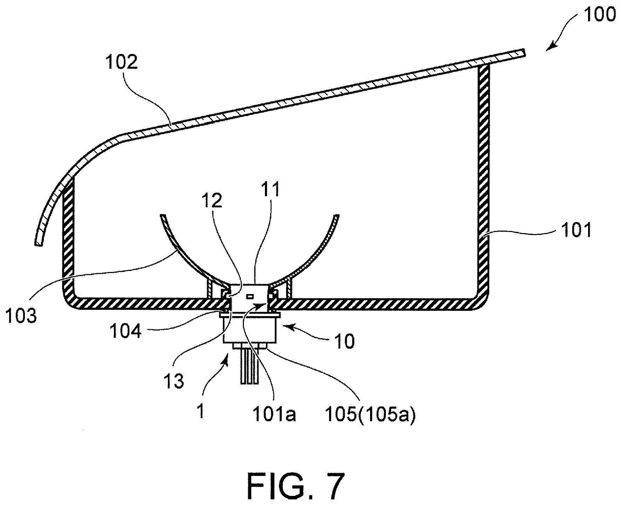

FIG. 7 is a schematic partial cross-sectional view for illustrating the vehicle lamp.

### DETAILED DESCRIPTION OF DISCLOSED EMBODIMENTS

Hereinafter, embodiments will be illustrated with reference to the drawings. In each drawing, similar components are assigned with the same reference numerals and detailed descriptions thereof will be omitted as appropriate.

### (Vehicle lighting device)

A vehicle lighting device 1 according to the present embodiment can be provided on, for example, an automobile or a railroad vehicle. The vehicle lighting device 1 provided on an automobile can be used as, for example, a front combination light (for example, a combination of a daytime running lamp (DRL), a position lamp, a turn signal lamp, etc.), a rear combination light (for example, a combination of a stop lamp, a tail lamp, a turn signal lamp, a back lamp, a fog lamp, etc.) or the like. However, the application of the vehicle lighting device 1 is not limited to these.

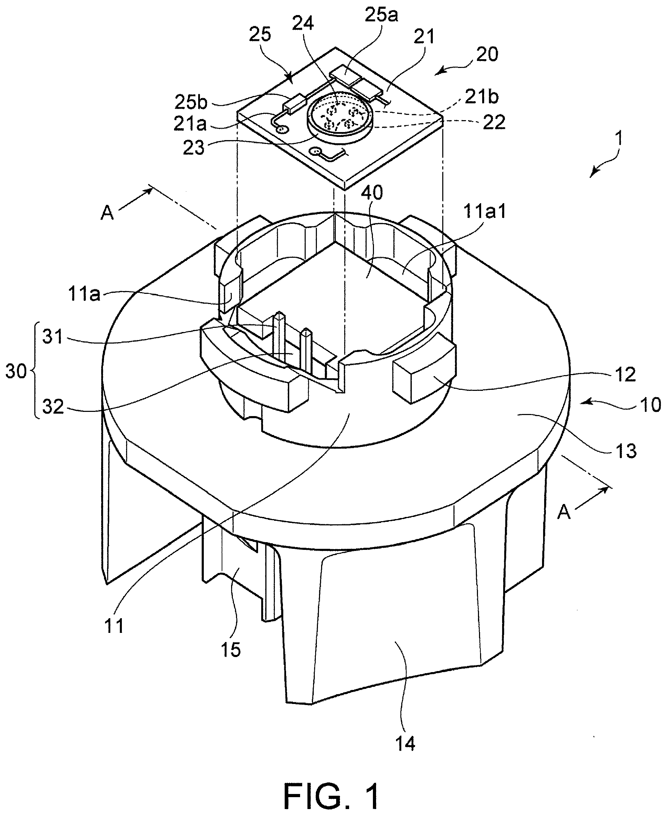

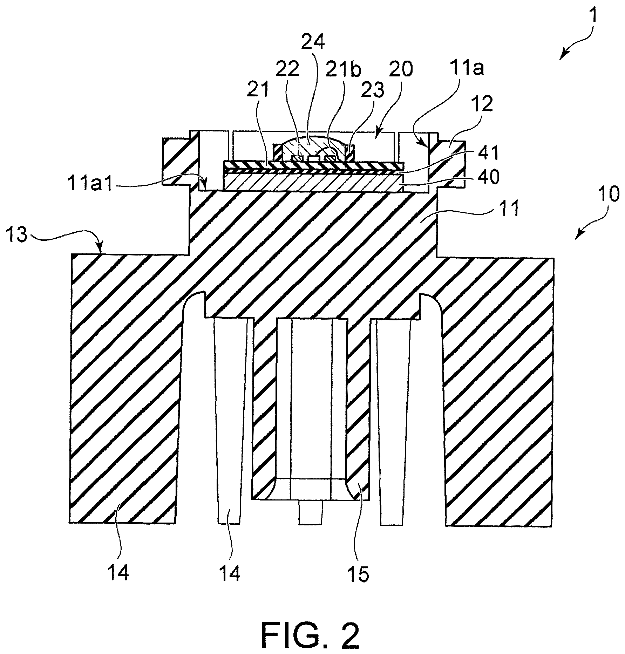

FIG. 1 is a schematic exploded view for illustrating the vehicle lighting device 1 according to the present embodiment. FIG. 2 is a cross-sectional view taken along the line A-A of the vehicle lighting device 1 in FIG. 1. As shown in FIG. 1 and FIG. 2, the vehicle lighting device 1 is provided with, for example, a socket 10, a light emitting module 20, a power feeding part 30, and a heat transfer part 40.

The socket 10 has, for example, a mounting part 11, a bayonet 12, a flange 13, a heat dissipation fin 14, and a connector holder 15. The mounting part 11 is provided on a surface of the flange 13 on a side opposite to the side where the heat dissipation fin 14 is provided. The outer shape of the mounting part 11 can be columnar. The outer shape of the mounting part 11 is, for example, a columnar shape. The mounting part 11 has, for example, a recess 11a that opens at an end on the side opposite to the side of the flange 13.

The bayonet 12 is provided, for example, on a side surface of the mounting part 11. The bayonet 12 protrudes toward the outer side of the vehicle lighting device 1. The bayonet 12 faces the flange 13. A plurality of bayonets 12 can be provided. The bayonet 12 is used when the vehicle lighting device 1 is mounted on a housing 101 of a vehicle lamp 100, which will be described later, for example. The bayonet 12 can be used for twist lock.

The flange 13 has, for example, a plate shape. The flange 13 has, for example, a substantially disk shape. A side surface of the flange 13 is located outside the vehicle lighting device 1 with respect to the side surface of the bayonet 12.

The heat dissipation fin 14 is provided on the side of the flange 13 opposite to the side of the mounting part 11. At least one heat dissipation fin 14 can be provided. For example, as shown in FIG. 2, the socket 10 can be provided with a plurality of heat dissipation fins 14. The plurality of heat dissipation fins 14 can be provided side by side in a predetermined direction. The heat dissipation fin 14 has, for example, a plate shape or a cylindrical shape.

The connector holder 15 is provided on the side of the flange 13 opposite to the side of the mounting part 11. The connector holder 15 can be provided side by side with the heat dissipation fin 14. The connector holder 15 has a cylindrical shape, and a connector 105 having a seal member 105a is inserted inside the connector holder 15.

The socket 10 has a function of holding the light emitting module 20 and the power feeding part 30, and a function of transferring the heat generated in the light emitting module 20 to the outside. Therefore, the socket 10 is preferably made of a material having high thermal conductivity. The socket 10 can be made of, for example, a metal such as aluminum and an aluminum alloy.

Further, in recent years, it is desired that the socket 10 can efficiently dissipate the heat generated in the light emitting module 20 and is lightweight. Therefore, the socket 10 can be made of, for example, a high thermal conductive resin. The high thermal conductive resin includes, for example, a resin and a filler using an inorganic material. The high thermal conductive resin is, for example, a resin such as PET (polyethylene terephthalate) and nylon mixed with a filler using carbon, aluminum oxide or the like. The heat transfer rate of the high thermal conductive resin can be, for example, about 8 W/(m·k) to 20 W/(m·k). The socket 10 illustrated in FIG. 1 and FIG. 2 is made of a high thermal conductive resin.

If the socket 10 contains a high thermal conductive resin and is integrally formed with the mounting part 11, the bayonet 12, the flange 13, the heat dissipation fin 14, and the connector holder 15, the heat generated in the light emitting module 20 can be efficiently dissipated. Further, the weight of the socket 10 can be reduced. In this case, the mounting part 11, the bayonet 12, the flange 13, the heat dissipation fin 14, and the connector holder 15 can be integrally molded using an injection molding method or the like. In addition, the socket 10, the power feeding part 30, and the heat transfer part 40 can be integrally molded using an insert molding method.

The light emitting module 20 (substrate 21) is provided on one end side of the socket 10. The light emitting module 20 includes, for example, a substrate 21, a light emitting element 22, a frame part 23, a sealing part 24, and a circuit element 25. The substrate 21 is adhered to, for example, the upper surface of the heat transfer part 40. In this case, the adhesive is preferably an adhesive having high thermal conductivity. The thermal conductivity of the adhesive is, for example, 0.5 W/(m·K) or more and 10 W/(m·K) or less. For example, the adhesive can be an adhesive mixed with a filler using an inorganic material. In this case, an adhesive layer 41 containing a filler using an inorganic material is formed between the substrate 21 and the heat transfer part 40.

The substrate 21 has a plate shape. The planar shape of the substrate 21 is, for example, a quadrangular shape. The substrate 21 can be made of, for example, an inorganic material such as ceramics (for example, aluminum oxide or aluminum nitride), an organic material such as paper phenol and glass epoxy or the like. Further, the substrate 21 may be a metal core substrate in which the surface of a metal plate is coated with an insulating material. When the amount of heat generated by the light emitting element 22 is large, it is preferable to form the substrate 21 using a material having high thermal conductivity from the viewpoint of heat dissipation. Examples of the material having high thermal conductivity can include ceramics such as aluminum oxide and aluminum nitride, a high thermal conductive resin, and a metal core substrate. The substrate 21 may have a single-layer structure or may have a multi-layer structure.

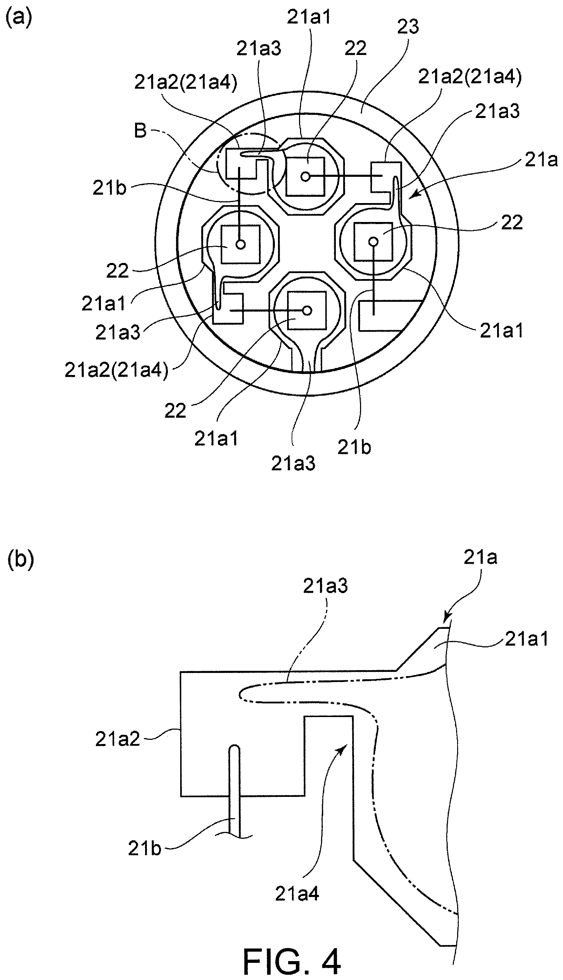

Furthermore, a wiring pattern 21a, which includes a mounting pad 21a1 and a connection pad 21a2 connected to the mounting pad 21a1, is provided on a surface of the substrate 21 (see, for example, (a) of FIG. 4, etc.). The wiring pattern 21a is made of, for example, a material containing silver as the main component, a material containing copper as the main component or the like.

Further, a cover part can also be provided to cover the wiring pattern 21a, a membranous resistor which will be described later or the like. The cover part contains, for example, a glass material.

The light emitting element 22 is provided on the substrate 21 (the surface of the substrate 21 on the side opposite to the side of the socket 10). As will be described later, the light emitting element 22 is bonded to the mounting pad 21a1 using a bonding material such as a die attaching material and a die attaching sheet. At least one light emitting element 22 can be provided. The vehicle lighting device 1 illustrated in FIG. 1 and FIG. 2 is provided with a plurality of light emitting elements 22. When a plurality of light emitting elements 22 are provided, the plurality of light emitting elements 22 can be connected in series with each other. The light emitting element 22 can be, for example, a light emitting diode, an organic light emitting diode, a laser diode or the like.

The light emitting element 22 can be a chip-shaped light emitting element. If a chip-shaped light emitting element 22 is used, the region in which the light emitting element 22 is provided can be reduced, so the substrate 21 can be miniaturized and eventually the vehicle lighting device 1 can be miniaturized. The chip-shaped light emitting element 22 can be mounted on the wiring pattern 21a (mounting pad 21a1) by COB (Chip On Board). The chip-shaped light emitting element 22 can be, for example, an upper and lower electrode type light emitting element. The upper electrode of the upper and lower electrode type light emitting element 22 can be electrically connected to the wiring pattern 21a (connection pad 21a2) by the wire wiring 21b. In this case, the wire wiring 21b can be connected by, for example, a wire bonding method. Details regarding the connection between the wire wiring 21b and the wiring pattern 21a will be described later.

The number, size, arrangement, etc. of the light emitting elements 22 are not limited to those illustrated, and can be appropriately changed according to the size and purpose of the vehicle lighting device 1.

The frame part 23 is provided on the substrate 21. The frame part 23 has a frame shape and is adhered to the substrate 21. The frame part 23 surrounds the light emitting element 22. The frame part 23 is made of, for example, a resin. The resin can be, for example, a thermoplastic resin such as PBT (polybutylene terephthalate), PC (polycarbonate), PET, nylon, PP (polypropylene), PE (polyethylene), and PS (polystyrene).

The frame part 23 can have a function of defining the formation range of the sealing part 24 and a function of a reflector. Therefore, the frame part 23 can contain particles of titanium oxide or contain a white resin in order to improve the reflectivity. Further, the frame part 23 can be omitted. However, if the frame part 23 is provided, the utilization efficiency of the light emitted from the light emitting element 22 can be improved. In addition, since the range in which the sealing part 24 is formed can be reduced, the light emitting module 20 can be miniaturized and eventually the vehicle lighting device 1 can be miniaturized.

The sealing part 24 is provided on the inner side of the frame part 23. The sealing part 24 is provided so as to cover the region surrounded by the frame part 23. The sealing part 24 is provided so as to cover the light emitting element 22 and the wire wiring 21b. The sealing part 24 contains a translucent resin. The sealing part 24 is formed, for example, by filling a resin on the inner side of the frame part 23. The filling of the resin is performed using, for example, a dispenser or the like. The resin to be filled is, for example, a silicone resin. When the frame part 23 is omitted, for example, a dome-shaped sealing part 24 is formed on the substrate 21.

Further, the sealing part 24 can contain a phosphor. The phosphor can be, for example, a YAG-based phosphor (yttrium-aluminum-garnet-based phosphor) or the like. However, the type of the phosphor can be appropriately changed so as to obtain a predetermined emission color according to the purpose of the vehicle lighting device 1.

The circuit element 25 can be a passive element or an active element used to constitute a light emitting circuit having the light emitting element 22. The circuit element 25 is provided, for example, around the frame part 23 and is electrically connected to the wiring pattern 21a. At least one circuit element 25 can be provided.

The circuit element 25 can be, for example, a resistor 25a and a protective element 25b. However, the type of the circuit element 25 is not limited to those illustrated, and can be appropriately changed according to the configuration of the light emitting circuit having the light emitting element 22. For example, in addition to the above, the circuit element 25 may be a capacitor, a positive characteristic thermistor, a negative characteristic thermistor, an inductor, a surge absorber, a varistor, a transistor such as a FET and a bipolar transistor, an integrated circuit, an arithmetic element or the like.

The resistor 25a is provided on the substrate 21. The resistor 25a is electrically connected to the wiring pattern 21a. The resistor 25a can be, for example, a surface mount type resistor, a resistor having a lead wire (metal oxide film resistor), a membranous resistor formed by using a screen printing method or the like. The resistor 25a illustrated in FIG. 1 is a membranous resistor.

The material of the membranous resistor is, for example, ruthenium oxide (RuO₂). The membranous resistor is formed using, for example, a screen printing method and a baking method. If the resistor 25a is a membranous resistor, the contact area between the resistor 25a and the substrate 21 can be increased, so the heat dissipation can be improved. In addition, a plurality of resistors 25a can be formed at one time. Therefore, the productivity can be improved. Further, it is possible to suppress variation in the resistance value among the plurality of resistors 25a.

Here, since the forward voltage characteristics of the light emitting element 22 vary, when the applied voltage between the anode terminal and the ground terminal is set constant, the brightness (luminous flux, luminance, luminous intensity, illuminance) of the light emitted from the light emitting element 22 varies. Therefore, the resistor 25a connected in series to the light emitting element 22 keeps the value of the current flowing through the light emitting element 22 within a predetermined range so that the brightness of the light emitted from the light emitting element 22 is kept within a predetermined range. In this case, the resistance value of the resistor 25a is changed so as to set the value of the current flowing through the light emitting element 22 within a predetermined range.

When the resistor 25a is a surface mount type resistor or a resistor having a lead wire, the resistor 25a having an appropriate resistance value is selected according to the forward voltage characteristics of the light emitting element 22. When the resistor 25a is a membranous resistor, the resistance value can be increased by removing a part of the resistor 25a. For example, a part of the membranous resistor can be easily removed if the membranous resistor is irradiated with a laser light. The number and size of the resistors 25a are not limited to those illustrated, and can be appropriately changed according to the number and specifications of the light emitting elements 22.

The protective element 25b is provided on the substrate 21. The protective element 25b is electrically connected to the wiring pattern 21a. The protective element 25b is provided, for example, to prevent a reverse voltage from being applied to the light emitting element 22, and prevent pulse noise from the reverse direction from being applied to the light emitting element 22. The protective element 25b can be, for example, a diode. The protective element 25b illustrated in FIG. 1 is a surface mount type diode.

In addition, an optical element can also be provided if necessary. The optical element can be provided, for example, on the sealing part 24. The optical element is, for example, a convex lens, a concave lens, a light guide body or the like.

The power feeding part 30 has, for example, a plurality of power feeding terminals 31 and a holding part 32. The plurality of power feeding terminals 31 can each have a rod shape. The plurality of power feeding terminals 31 are provided, for example, side by side in a predetermined direction. One end of each of the plurality of power feeding terminals 31 protrudes from the bottom surface 11a1 of the recess 11a. One end of each of the plurality of power feeding terminals 31 is soldered to the wiring pattern 21a provided on the substrate 21. The other end of each of the plurality of power feeding terminals 31 is exposed inside the hole of the connector holder 15. The connector 105 is fitted to the plurality of power supply terminals 31 exposed inside the hole of the connector holder 15. The plurality of power feeding terminals 31 are made of, for example, a metal such as a copper alloy. The shape, arrangement, material, etc. of the plurality of power feeding terminals 31 are not limited to those illustrated, and can be appropriately changed.

As described above, the socket 10 is preferably made of a material having high thermal conductivity. However, the material having high thermal conductivity may have electrical conductivity. For example, a metal such as an aluminum alloy or a high thermal conductive resin containing a filler using carbon has electrical conductivity. Therefore, the holding part 32 is provided to insulate between the plurality of power feeding terminals 31 and the socket 10 that has electrical conductivity. The holding part 32 also has a function of holding the plurality of power feeding terminals 31. When the socket 10 is made of an insulating high thermal conductive resin (for example, a high thermal conductive resin containing a filler using aluminum oxide), the holding part 32 can be omitted. In this case, the socket 10 holds the plurality of power feeding terminals 31. The holding part 32 is made of, for example, an insulating resin. The holding part 32 can be press-fitted into the hole provided in the socket 10 or adhered to the inner wall of the hole, for example.

The heat transfer part 40 has a plate shape and is provided between the socket 10 and the light emitting module 20 (substrate 21). The upper surface of the heat transfer part 40 is exposed from the end of the socket 10 on the side where the light emitting module 20 is provided. For example, as shown in FIG. 2, the heat transfer part 40 can be adhered to the bottom surface 11a1 of the recess 11a. Further, the heat transfer part 40 may be adhered to the inside of a recess provided on the bottom surface 11a1 of the recess 11a. In addition, the heat transfer part 40 may be adhered on a convex pedestal provided on the bottom surface 11al of the recess 11a. The adhesive for adhering the heat transfer part 40 and the socket 10 is preferably an adhesive having high thermal conductivity. For example, the adhesive can be the same as the adhesive that adheres the light emitting module 20 (substrate 21) and the heat transfer part 40 described above.

Furthermore, the heat transfer part 40 and the socket 10 can be integrally molded by an insert molding method. In addition, the heat transfer part 40 may be attached to the socket 10 via a layer containing thermal conductive grease (heat dissipation grease). The thermal conductive grease is obtained, for example, by mixing a modified silicone with a filler using an inorganic material. The thermal conductivity of the thermal conductive grease is, for example, 1 W/(m·K) or more and 5 W/(m·K) or less.

The heat transfer part 40 is provided in order to easily transfer the heat generated in the light emitting module 20 to the socket 10. Therefore, the heat transfer part 40 is made of a material having high thermal conductivity. For example, the heat transfer part 40 can be made of a metal such as aluminum, an aluminum alloy, copper, and a copper alloy.

Further, when a large amount of heat is generated in the light emitting module 20, at least one heat transfer fin can be further provided. For example, the heat transfer fin has a plate shape or a columnar shape, and inside the socket 10, one end of the heat transfer fin can be provided on the lower surface of the heat transfer part 40 and the other end can be provided in the vicinity of the heat dissipation fin 14. The heat transfer part 40 and the heat transfer fin can be integrally formed.

Furthermore, for example, when the heat generated in the light emitting module 20 is relatively little or when it is desired to reduce the weight of the vehicle lighting device 1, the heat transfer part 40 may be omitted. Further, when the socket 10 is made of a metal such as an aluminum alloy, the heat transfer part 40 is omitted. When the heat transfer part 40 is omitted, the light emitting module 20 (substrate 21) is adhered to the end of the socket 10. For example, the light emitting module 20 (substrate 21) can be adhered to the bottom surface 11a1 of the recess 11a, or the light emitting module 20 (substrate 21) can be adhered onto the convex pedestal provided on the bottom surface 11a1 of the recess 11a. For example, the adhesive can be the same as the adhesive that adheres the light emitting module 20 (substrate 21) and the heat transfer part 40 described above.

Next, the connection between the wire wiring 21b and the wiring pattern 21a will be further described. When the temperature of the sealing part 24 changes due to the turning on and off of the light emitting element 22, the sealing part 24 has thermal deformation (expansion and contraction due to the temperature change). When the sealing part 24 is thermally deformed, stress is generated in the light emitting element 22 and the wire wiring 21b covered by the sealing part 24.

In this case, the temperature of the atmosphere in which the vehicle lighting device 1 is provided varies, for example, in a range of -40 °C to 85 °C. Further, in recent years, the value of the current flowing through the light emitting element 22 has increased due to the high luminous flux of the vehicle lighting device 1, and the amount of heat generated by the light emitting element 22 has increased. When the temperature change of the atmosphere is large or the amount of heat generated by the light emitting element 22 increases, the amount of thermal deformation of the sealing part 24 increases, and the stress generated in the light emitting element 22 and the wire wiring 21b increases. When the stress generated in the light emitting element 22 and the wire wiring 21b increases, the light emitting element 22 may be peeled off, the wire wiring 21b may be disconnected, or the connection portion of the wire wiring 21b may be peeled off.

In this case, the amount of thermal deformation of the sealing part 24 increases outward from the center of the sealing part 24, so if the size of the sealing part 24 is reduced, the amount of thermal deformation can be reduced and eventually the stress generated in the light emitting element 22 and the wire wiring 21b can be reduced. For example, the size of the sealing part 24 can be reduced if the region in which the light emitting element 22 and the wire wiring 21b are provided is made small.

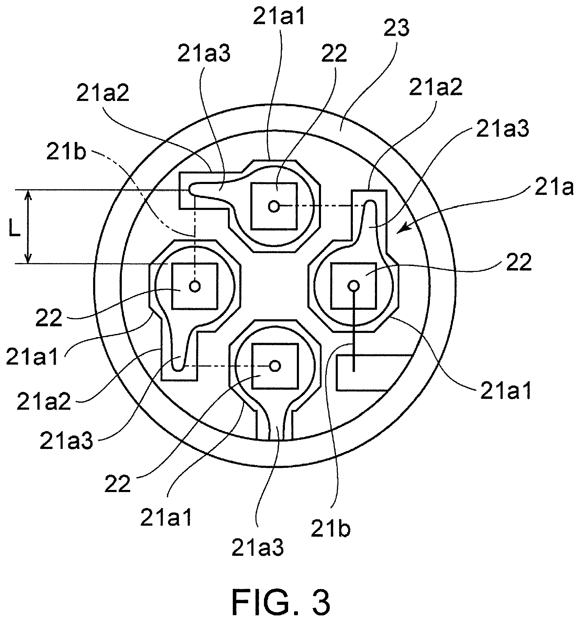

FIG. 3 is a schematic plan view for illustrating the connection between the wire wiring 21b and the wiring pattern 21a according to a comparative example. As shown in FIG. 3, the wiring pattern 21a is provided with the mounting pad 21a1 to which the light emitting element 22 is bonded and the connection pad 21a2 to which the wire wiring 21b is connected. The connection pad 21a2 is provided integrally with the mounting pad 21a1. When a plurality of upper and lower electrode type light emitting elements 22 are connected in series, a plurality of sets of mounting pads 21a1 and connection pads 21a2 provided integrally are provided.

Here, when the size of the sealing part 24 is reduced in order to reduce the amount of thermal deformation of the sealing part 24, as shown in FIG. 3, the region in which the mounting pad 21a1 and the connection pad 21a2 are provided becomes small. Therefore, the distance L between the position where the wire wiring 21b is connected to the connection pad 21a2 (the connection position of the wire wiring 21b) and the light emitting element 22 is shortened.

Generally, the light emitting element 22 is bonded to the mounting pad 21a1 using a bonding material such as a die attaching material and a die attaching sheet. Since the bonding material is paste-like or has adhesiveness, when the light emitting element 22 is bonded to the mounting pad 21a1, a component 21a3 of the bonding material may squeeze out and protrude from the light emitting element 22.

As shown in FIG. 3, when the mounting pad 21a1 and the connection pad 21a2 are simply integrated, the component 21a3 of the protruding bonding material may flow onto the upper surface of the connection pad 21a2 (the surface to which the wire wiring 21b is connected) and reach the connection position of the wire wiring 21b.

Generally, the wire wiring 21b is connected to the connection pad 21a2 using a wire bonding method after bonding the light emitting element 22. Therefore, if the component 21a3 of the protruding bonding material is at the connection position of the wire wiring 21b, it becomes difficult to connect the wire wiring 21b.

Thus, in the vehicle lighting device 1 according to the present embodiment, a suppression part is provided to suppress the component 21a3 of the bonding material protruding from the light emitting element 22 from reaching the position where the wire wiring 21b is connected to the connection pad 21a2.

(a) of FIG. 4 is a schematic plan view for illustrating a suppression part 21a4 which does not form part of the claimed invention. (b) of FIG. 4 is a schematic enlarged view of the part B in (a) of FIG. 4. Similar to the comparative example described with reference to FIG. 3, the connection pad 21a2 is provided integrally with the mounting pad 21a1. However, in the present embodiment, as shown in (a) and (b) of FIG. 4, the suppression part 21a4 having a concave shape is provided on the connection pad 21a2. The suppression part 21a4 is provided between an end of the connection pad 21a2 on the side of the mounting pad 21a1 and the position where the wire wiring 21b is connected to the connection pad 21a2. The suppression part 21a4 opens on the upper surface of the connection pad 21a2. The suppression part 21a4 may or may not penetrate the connection pad 21a2 in the thickness direction. One end of the suppression part 21a4 is provided inside the connection pad 21a2 as viewed from a direction perpendicular to the upper surface of the connection pad 21a2. The other end of the suppression part 21a4 may be located at the peripheral edge of the connection pad 21a2 or may be provided inside the connection pad 21a2.

The component 21a3 of the bonding material protruding from the light emitting element 22 flows into the concave suppression part 21a4. Therefore, it is possible to suppress the component 21a3 of the protruding bonding material from reaching the connection position of the wire wiring 21b. Further, even if the component 21a3 of the protruding bonding material flows onto the upper surface of the connection pad 21a2, as shown in (b) of FIG. 4, the component 21a3 of the bonding material can be separated from the connection position of the wire wiring 21b.

As described above, when the concave suppression part 21a4 is provided, it is possible to suppress the component 21a3 of the protruding bonding material from reaching the connection position of the wire wiring 21b even if the size of the sealing part 24 is reduced. Further, since the suppression part 21a4 can be formed together with the connection pad 21a2, the manufacturing cost does not increase.

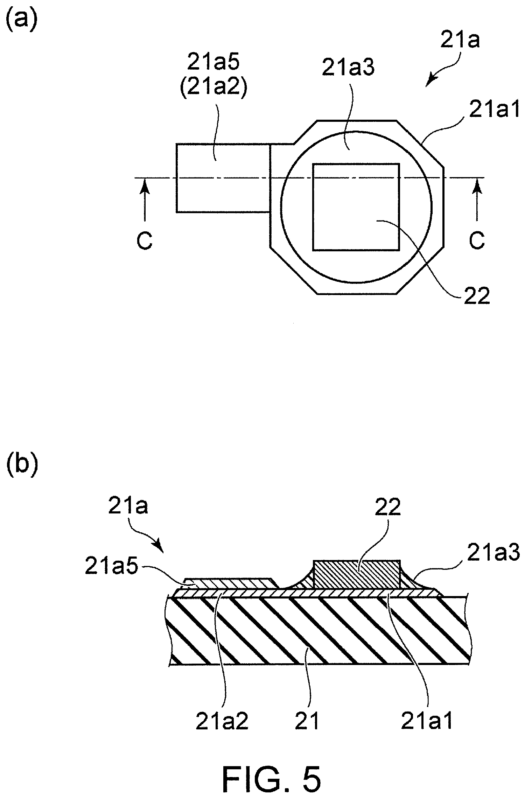

(a) of FIG. 5 is a schematic plan view for illustrating the suppression part 21a5 according to an embodiment of the invention. (b) of FIG. 5 is a cross-sectional view taken along the line C-C in (a) of FIG. 5. Similar to the comparative example described with reference to FIG. 3, the connection pad 21a2 is provided integrally with the mounting pad 21a1. However, in the present embodiment, as shown in (a) and (b) of FIG. 5, the membranous suppression part 21a5 is provided on the connection pad 21a2. It suffices if the suppression part 21a5 is provided on the connection pad 21a2 in a region including the connection position of the wire wiring 21b. For example, as shown in (a) and (b) of FIG. 5, the suppression part 21a5 can be provided over the entire region on the connection pad 21a2. The suppression part 21a5 can be provided integrally with the connection pad 21a2. The thickness of the suppression part 21a5 is not particularly limited, but for example, the thickness of the suppression part 21a5 can be about the same as the thickness of the connection pad 21a2.

The material of the suppression part 21a5 may be any electrically conductive material. However, if the material of the suppression part 21a5 is the same as the material of the connection pad 21a2, the suppression part 21a5 and the connection pad 21a2 can be formed together. For example, the suppression part 21a5 can be formed by making the thickness of the connection pad 21a2 greater than the thickness of the mounting pad 21a1. Generally, the wiring pattern 21a is formed using a screen printing method. Therefore, the thickness of the mounting pad 21a1 or the connection pad 21a2 can be changed by changing the number of times of printing the mounting pad 21a1 or the connection pad 21a2 when forming the wiring pattern 21a. In addition, the thickness of the mounting pad 21a1 or the connection pad 21a2 can also be changed by changing the thickness of a part of a metal mask used in the screen printing method.

If the membranous suppression part 21a5 is provided on the connection pad 21a2, the component 21a3 of the protruding bonding material is less likely to intrude into the upper surface of the suppression part 21a5. Therefore, it is possible to suppress the component 21a3 of the protruding bonding material from reaching the connection position of the wire wiring 21b.

As described above, when the membranous suppression part 21a5 is provided on the connection pad 21a2, it is possible to suppress the component 21a3 of the protruding bonding material from reaching the connection position of the wire wiring 21b even if the size of the sealing part 24 is reduced. Further, since the suppression part 21a5 having electrical conductivity is provided on the connection pad 21a2, the electrical resistance of the connection pad 21a2 does not increase.

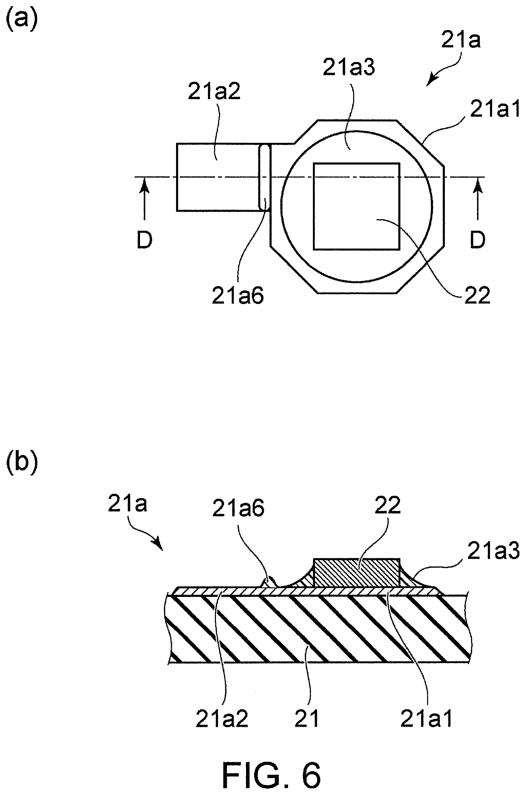

(a) of FIG. 6 is a schematic plan view for illustrating the suppression part 21a6 according to another embodiment of the invention. (b) of FIG. 6 is a cross-sectional view taken along the line D-D in (a) of FIG. 6. Similar to the comparative example described with reference to FIG. 3, the connection pad 21a2 is provided integrally with the mounting pad 21a1. However, in the present embodiment, as shown in (a) and (b) of FIG. 6, the suppression part 21a6 having a convex shape is provided on the connection pad 21a2. The suppression part 21a6 is provided between an end of the connection pad 21a2 on the side of the mounting pad 21a1 and the position where the wire wiring 21b is connected to the connection pad 21a2. For example, the suppression part 21a6 can be provided at the position of the end of the connection pad 21a2 on the side of the mounting pad 21a1. The suppression part 21a6 has a linear shape and extends in a direction intersecting the extending direction of the connection pad 21a2. A plurality of suppression parts 21a6 having a dot shape can be provided side by side in the direction intersecting the extending direction of the connection pad 21a2. The thickness (height) of the suppression part 21a6 is not particularly limited, but for example, the thickness of the suppression part 21a6 can be greater than the thickness of the connection pad 21a2.

The suppression part 21a6 can be formed by applying a glass resist, a thermosetting resin or the like on the connection pad 21a2 using a dispenser or the like, for example.

If the suppression part 21a6 having a convex shape is provided on the connection pad 21a2, the component 21a3 of the protruding bonding material is less likely to intrude into the upper surface of the connection pad 21a2. Therefore, it is possible to suppress the component 21a3 of the protruding bonding material from reaching the connection position of the wire wiring 21b.

As described above, when the suppression part 21a6 having a convex shape is provided, it is possible to suppress the component 21a3 of the protruding bonding material from reaching the connection position of the wire wiring 21b even if the size of the sealing part 24 is reduced. Further, since the thickness of the connection pad 21a2 does not change, the electrical resistance of the connection pad 21a2 does not increase.

As described above, when the suppression part is provided to suppress the component 21a3 of the bonding material protruding from the light emitting element 22 from reaching the position where the wire wiring 21b is connected to the connection pad 21a2, it is possible to prevent the difficulty in connecting the wire wiring 21b even if the size of the sealing part 24 is reduced. Further, since the size of the sealing part 24 can be reduced, the stress generated in the light emitting element 22 and the wire wiring 21b can be reduced. Therefore, the reliability of the vehicle lighting device 1 can be improved. In addition, since the size of the sealing part 24 can be reduced, the material cost of the sealing part 24 can be reduced and eventually the manufacturing cost of the vehicle lighting device 1 can be reduced. Furthermore, since the size of the sealing part 24 can be reduced, the light emitting module 20 can be miniaturized and eventually the vehicle lighting device 1 can be miniaturized.

### (Vehicle lamp)

Next, the vehicle lamp 100 will be illustrated. The following describes a case where the vehicle lamp 100 is a front combination light provided on an automobile as an example. However, the vehicle lamp 100 is not limited to the front combination light provided on the automobile. The vehicle lamp 100 may be any vehicle lamp that is provided on an automobile, a railroad vehicle or the like.

FIG. 7 is a schematic partial cross-sectional view for illustrating the vehicle lamp 100. As shown in FIG. 7, the vehicle lamp 100 includes, for example, the vehicle lighting device 1, the housing 101, the cover 102, the optical element 103, the seal member 104, and the connector 105.

The vehicle lighting device 1 is attached to the housing 101. The housing 101 holds the mounting part 11. The housing 101 has a box shape with one end side open. The housing 101 is made of, for example, a resin that does not transmit light. The bottom surface of the housing 101 is provided with an attachment hole 101a into which a portion of the mounting part 11 provided with the bayonet 12 is inserted. A recess for inserting the bayonet 12 provided on the mounting part 11 is provided on the peripheral edge of the attachment hole 101a. Although it is illustrated that the attachment hole 101a is directly provided in the housing 101, an attachment member having the attachment hole 101a may be provided in the housing 101.

When the vehicle lighting device 1 is attached to the vehicle lamp 100, the portion of the mounting part 11 provided with the bayonet 12 is inserted into the attachment hole 101a, and the vehicle lighting device 1 is rotated. Then, for example, the bayonet 12 is held in a fitting part provided on the peripheral edge of the attachment hole 101a. Such an attaching method is called twist lock.

The cover 102 is provided to close the opening of the housing 101. The cover 102 is made of a translucent resin or the like. The cover 102 can also have a function of a lens.

The light emitted from the vehicle lighting device 1 is incident on the optical element 103. The optical element 103 reflects, diffuses, guides, collects light, and forms a predetermined light distribution pattern of the light emitted from the vehicle lighting device 1. For example, the optical element 103 illustrated in FIG. 7 is a reflector. In this case, the optical element 103 reflects the light emitted from the vehicle lighting device 1 to form a predetermined light distribution pattern.

The seal member 104 is provided between the flange 13 and the housing 101. The seal member 104 has an annular shape and is made of an elastic material such as rubber and a silicone resin.

When the vehicle lighting device 1 is attached to the vehicle lamp 100, the seal member 104 is sandwiched between the flange 13 and the housing 101. Therefore, the internal space of the housing 101 can be sealed by the seal member 104. Further, the bayonet 12 is pressed against the housing 101 by the elastic force of the seal member 104. Therefore, it is possible to prevent the vehicle lighting device 1 from being detached from the housing 101.

The connector 105 is fitted to the ends of the plurality of power feeding terminals 31 exposed inside the connector holder 15. A power supply (not shown) or the like is electrically connected to the connector 105. Therefore, by fitting the connector 105 to the ends of the plurality of power feeding terminals 31, the power supply (not shown) or the like can be electrically connected to the light emitting element 22.

In addition, the connector 105 is provided with the seal member 105a. When the connector 105 having the seal member 105a is inserted into the connector holder 15, the inside of the connector holder 15 is sealed to be watertight.

### Reference Signs List

1 vehicle lighting device, 10 socket, 20 light emitting module, 21 substrate, 21a1 mounting pad, 21a2 connection pad, 21a3 component of bonding material, 21a4 suppression part, 21a5 suppression part, 21a6 suppression part, 21b wire wiring, 22 light emitting element, 100 vehicle lamp, 101 housing

## Claims

1. A vehicle lighting device (1), comprising:
a socket (10);
a substrate (21) provided on one end side of the socket and having a wiring pattern (21a) that comprises a mounting pad (21a1) and a connection pad (21a2) connected to the mounting pad, and the substrate further having another connection pad (21a2);
a light emitting element (22) being chip-shaped and bonded to the mounting pad using a bonding material;
a wire wiring (21b) connected to an electrode of the light emitting element and the other connection pad (21a2), and the vehicle lighting device further comprises another wire wiring (21b);
a sealing part (24) covering the light emitting element and the wire wiring; and
a suppression part (21a5) suppressing a component (21a3) of the bonding material protruding from the light emitting element from reaching a position where the other wire wiring (21b) is connected to the connection pad (21a2),
**characterized in that** the suppression part (21a5) is membranous and is provided on the connection pad (21a2).

2. A vehicle lighting device (1), comprising:
a socket (10);
a substrate (21) provided on one end side of the socket and having a wiring pattern (21a) that comprises a mounting pad (21a1) and a connection pad (21a2) connected to the mounting pad, and the substrate further having another connection pad (21a2);
a light emitting element (22) being chip-shaped and bonded to the mounting pad using a bonding material;
a wire wiring (21b) connected to an electrode of the light emitting element and the other connection pad (21a2), and the vehicle lighting device further comprises another wire wiring (21b);
a sealing part (24) covering the light emitting element and the wire wiring; and
a suppression part (21a6) suppressing a component (21a3) of the bonding material protruding from the light emitting element from reaching a position where the other wire wiring (21b) is connected to the connection pad (21a2),
**characterized in that** the suppression part (21a6) has a convex shape that protrudes upwardly from
and is provided on the connection pad (21a2), and is provided between an end of the connection pad on a mounting pad side and the position where the other of wire wiring (21b) is connected to the connection pad (21a2).

3. A vehicle lamp (100), comprising:
the vehicle lighting device (1) according to claim 1 or 2; and
a housing (101) to which the vehicle lighting device is attached.

## Patentansprüche

1. Fahrzeugbeleuchtungsvorrichtung (1), umfassend:
eine Fassung (10);
ein Substrat (21), das an einer Endseite der Fassung vorgesehen ist und ein Verdrahtungsmuster (21a) aufweist, das ein Montagepad (21a1) und ein mit dem Montagepad verbundenes Verbindungspad (21a2) umfasst, und das Substrat ferner ein weiteres Verbindungspad (21a2) aufweist;
ein lichtemittierendes Element (22), das chipförmig ist und unter Verwendung eines Bondmaterials an das Montagepad gebondet ist;
ein Bonddraht (21b), der mit einer Elektrode des lichtemittierenden Elements und dem anderen Verbindungspad (21a2) verbunden ist, und die Fahrzeugbeleuchtungsvorrichtung ferner einen weiteren Bonddraht (21b) umfasst;
ein Abdichtteil (24), das das lichtemittierende Element und den Bonddraht abdeckt; und
ein Sperrteil (21a5), das verhindert, dass ein aus dem lichtemittierenden Element herausragender Bestandteil (21a3) des Bondmaterials eine Position erreicht, an der der andere Bonddraht (21b) mit dem Verbindungspad (21a2) verbunden ist,
**dadurch gekennzeichnet, dass**
das Sperrteil (21a5) membranartig ist und auf dem Verbindungspad (21a2) vorgesehen ist.

2. Fahrzeugbeleuchtungsvorrichtung (1), umfassend:
eine Fassung (10);
ein Substrat (21), das an einer Endseite der Fassung vorgesehen ist und ein Verdrahtungsmuster (21a) aufweist, das ein Montagepad (21a1) und ein mit dem Montagepad verbundenes Verbindungspad (21a2) umfasst, und das Substrat ferner ein weiteres Verbindungspad (21a2) aufweist;
ein lichtemittierendes Element (22), das chipförmig ist und unter Verwendung eines Bondmaterials an das Montagepad gebondet ist;
ein Bonddraht (21b), der mit einer Elektrode des lichtemittierenden Elements und dem anderen Verbindungspad (21a2) verbunden ist, und die Fahrzeugbeleuchtungsvorrichtung ferner einen weiteren Bonddraht (21b) umfasst;
ein Abdichtteil (24), das das lichtemittierende Element und den Bonddraht abdeckt; und
ein Sperrteil (21a6), das verhindert, dass ein aus dem lichtemittierenden Element herausragender Bestandteil (21a3) des Bondmaterials eine Position erreicht, an der der andere Bonddraht (21b) mit dem Verbindungspad (21a2) verbunden ist,
**dadurch gekennzeichnet, dass**
das Sperrteil (21a6) eine konvexe Form aufweist, die nach oben aus dem Verbindungspad (21a2) herausragt und auf diesem vorgesehen ist, und zwischen einem Ende des Verbindungspads auf einer Montagepadseite und der Position vorgesehen ist, an der der andere Bonddraht (21b) mit dem Verbindungspad (21a2) verbunden ist.

3. Fahrzeugleuchte (100), umfassend:
die Fahrzeugbeleuchtungsvorrichtung (1) nach Anspruch 1 oder 2; und
ein Gehäuse (101), an dem die Fahrzeugbeleuchtungsvorrichtung angebracht ist.

## Revendications

1. Dispositif d'éclairage pour véhicule (1), comprenant:
une douille (10);
un substrat (21) prévu sur un côté d'extrémité de la douille et comportant un motif de câblage (21a) qui comprend une plage de montage (21a1) et une plage de connexion (21a2) connectée à la plage de montage, le substrat comportant en outre une autre plage de connexion (21a2); un élément émetteur de lumière (22) en forme de puce et lié à la plage de montage à l'aide d'un matériau de liaison;
un câblage (21b) connecté à une électrode de l'élément émetteur de lumière et à l'autre plage de connexion (21a2), et le dispositif d'éclairage pour véhicule comprend en outre un autre câblage (21b);
une partie d'étanchéité (24) recouvrant l'élément émetteur de lumière et le câblage; et
une partie de suppression (21a5) empêchant un composant (21a3) du matériau de liaison dépassant de l'élément émetteur de lumière d'atteindre une position où l'autre fil de câblage (21b) est connecté à la plage de connexion (21a2),**caractérisé en ce que** la partie de suppression (21a5) est membraneuse et est prévue sur la plage de connexion (21a2).

2. Dispositif d'éclairage pour véhicule (1), comprenant:
une douille (10);
un substrat (21) prévu sur un côté d'extrémité de la douille et comportant un motif de câblage (21a) qui comprend une plage de montage (21a1) et une plage de connexion (21a2) connectée à la plage de montage, le substrat comportant en outre une autre plage de connexion (21a2);
un élément émetteur de lumière (22) en forme de puce et lié à la plage de montage à l'aide d'un matériau de liaison;
un câblage filaire (21b) connecté à une électrode de l'élément émetteur de lumière et à l'autre plage de connexion (21a2), et le dispositif d'éclairage pour véhicule comprend en outre un autre câblage filaire (21b);
une partie d'étanchéité (24) recouvrant l'élément émetteur de lumière et le câblage filaire; et
une partie de suppression (21a6) empêchant un composant (21a3) du matériau de liaison dépassant de l'élément émetteur de lumière d'atteindre une position où l'autre câblage filaire (21b) est connecté au plage de connexion (21a2),**caractérisé en ce que** la partie de suppression (21a6) a une forme convexe qui dépasse vers le haut et est prévue sur la plage de connexion (21a2), et est prévue entre une extrémité de la plage de connexion du côté de la plage de montage et la position où l'autre câblage (21b) est connecté à la plage de connexion (21a2).

3. Lampe de véhicule (100), comprenant:
le dispositif d'éclairage de véhicule (1) selon la revendication 1 ou 2; et
un boîtier (101) auquel le dispositif d'éclairage de véhicule est fixé.
